# EUROPEAN PATENT APPLICATION

(11) **EP 4 819 806 A1**
(43) Date of publication of application: **07.10.2026**
(21) Application number: 25167971.8
(22) Date of filing: 02.04.2025
(51) Int. Cl.: H10K 30/40, H10K 85/50, H10K 71/15

(54) **FORMATION OF A PEROVSKITE LAYER AND RELATED COATING LIQUID USES AND PHOTOELECTRIC DEVICE**

(71) Applicant: TOYOTA JIDOSHA KABUSHIKI KAISHA, Toyota-shi, Aichi-ken, 471-8571 (JP); RIJKSUNIVERSITEIT GRONINGEN, 9712 CP Groningen (NL)
(72) Inventor: KINGE, Sachin, 1140 BRUSSELS (BE); LOI, Maria Antonietta, 9747 AG GRONINGEN (NL); CHEN, Lijun, 9747 AG GRONINGEN (NL)
(74) Representative: Cabinet Beau de Loménie

(57) **Abstract**

A solar cell's perovskite structure, layers of which are spaced apart from each other via the organic cations, is formed with
coating a surface of a heated support (30°C-70°C) with a first blade coating operation of applying at less than 18 mm/s a first liquid comprising a mix of polar aprotic solvents and tin salt dissolved therein, followed by a waiting time of 2s or more and then evaporation of the first solvent for forming crystals with the tin salt and annealing the crystals for obtaining an annealed layer on the support,
coating the annealed layer with a second blade coating operation of applying a second liquid comprising a lower alkyl alcohol and a halogenated lower alkyl alcohol and salts of organic cations therein,
heating for evaporation of the second solvent from the second liquid, followed by annealing.

## Description

### BACKGROUND OF THE INVENTION

### 1. Field of the invention

The present disclosure relates to a method for forming a perovskite layer of a perovskite solar cell, a photoelectric device of which a perovskite layer is formed with the method and uses of specific liquids in coating operations in the method.

### 2. Description of Related Art

Perovskite solar cells (PSCs) are known with a perovskite layer formed between a hole transport layer and an electron transport layer. Performant PSCs are known in which the perovskite layer is a lead based layer or according to recent developments a tin based layer, shown e.g. in JP 2019-38714 A, EP 3 958 336 A1 or JP 7 429 881 B2. As a base material for forming the hole transport layer of a perovskite solar cell is a polymer component, e.g. from the product PEDOT:PSS is known which combines Poly(3,4-ethylenedioxythiophene) and polystyrene sulfonate. The product is available e.g. from Xi'an Polymer Light Technology Corp. in Xi'an, China or under the trademark CLEVIOS from Heraeus Epurio GmbH, CHEMPARK Leverkusen, 51368 Leverkusen, Germany. It is supposed to provide stability of a hole transport layer in a perovskite solar cell, specifically regularly structured n-i-p type cells. Other known polymers for such a polymer component suitable as a base material for forming the hole transport layer are poly[bis(4-phenyl)(2,4,6-triMethylphenyl)amine] (PTAA) and poly(3-hexylthiophene) (P3HT). These polymer components include a conductive polymer like a thiophene-based polymer. A hole transport layer of a perovskite solar cell further includes a spiro compound as a charge transfer agent.

Of the type of cell with a perovskite layer formed between a hole transport layer and an electron transport layer literatures (1) to (4) listed below show a layer stacking sequence as follows:

### ITO/PEDOT:PSS/Sn PVSK/C60/BCP/Ag

Here ITO is an indium tin oxide substrate provided with an electrode pattern, PEDOT:PSS is a hole transport layer formed of a polymer material known as PEDOT:PSS, Sn PVSK is a perovskite layer being a tin based layer, C60 is an electron transport layer formed by a deposition of C60, BCP is a buffer layer formed of bathocuproine, and Ag is a transparent electrode formed of a deposition of Ag. Whereas according to literatures (1) to (4) the perovskite layer is one obtained from a spin coating operation, literature (5) listed below shows the above layer stacking sequence with a blade coating operation used for forming the perovskite layer.

Using lead-based compounds raises concerns about possible effects on the environment in case of massive exploitation. Tin perovskite emerges as one of the most promising Pb-free alternatives owing to its ideal band gap, closely approaching the Shockley-Queisser limit (1.3-1.4 eV), along with its high carrier mobility, however, with challenges such as defect tolerance, rapid crystallization, and oxidative stability. Spin coating has several limitations in terms of scalability, substrate dimension, cost reduction, deposition speed, and yield. Blade coating instead for scalable fabrication of PSCs is still far from achieving efficiency values expected for commercialization and homogenous crystallization and particularly involves the formation of a meniscus-shaped liquid edge of precursor solutions and a challenge to control the nucleation and crystal growth processes to achieve dense and uniform films through natural drying.

As discussed in literature (6) listed below perovskite structures for perovskite layers are classified specifically depending on spacing between single or multiple layers of octahedral crystal units like SnI₆⁴⁻ into perovskite structure or perovskite layer types including 2D perovskites, quasi-2D perovskites and 3D perovskites. In particular perovskites with multiple layers formed of a number of 2, 3, 4 or 5 (stacked) layers are categorized as quasi-2D perovskites and perovskites with a large number of layers (stacked) layers are categorized as 3D perovskites, whereas perovskites with a large number of layers (stacked) layers modified by adding spacers are categorized as 3D/2D perovskites.

Here cations serve in particular depending on their size for connecting or stacking the multiple layers or as spacers to prevent connecting or stacking of two adjacent layers having the spacers between them.

### Literature

(1) E. Jokar, C. H. Chien, C. M. Tsai, A. Fathi, E. W. Diau, "Robust Tin-Based Perovskite Solar Cells with Hybrid Organic Cations to Attain Efficiency Approaching 10", Adv. Mater., 2019, 31, e1804835
(2) E. Jokar, H. S. Chuang, C. H. Kuan, H. P. Wu, C. H. Hou, J. J. Shyue, E. Wei-Guang Diau, " Slow passivation and inverted hysteresis for hybrid tin perovskite solar cells attaining 13.5% via sequential deposition", J. Phys. Chem. Lett., 2021, 12, 10106
(3) E. Jokar, P.-Y. Cheng, C.-Y. Lin, S. Narra, S. Shahbazi, E. Wei-Guang Diau, " Enhanced performance and stability of 3D/2D tin perovskite solar cells fabricated with a sequential solution deposition", ACS Energy Letters, 2021, 6, 485
(4) Y. Jiang, Z. Lu, S. Zou, H. Lai, Z. Zhang, J. Luo, Y. Huang, R. He, J. Jin, Z. Yi, Y. Luo, W. Wang, C. Wang, X. Hao, C. Chen, X. Wang, Y. Wang, S. Ren, T. Shi, F. Fu, D. Zhao, "Dual-site passivation of tin-related defects enabling efficient lead-free tin perovskite solar cells", Nano Energy, 2022, 103, 107818
(5) W. Zuraw, F. A. Vinocour Pacheco, J. Sanchez-Diaz, L. Przypis, M. A. Mejia Escobar, S. Almosni, G.,Vescio, J. P. Martinez-Pastor, B. Garrido, R. Kudrawiec, I. Mora-Sero, S. Oz, "Large-Area, Flexible, Lead-Free Sn-Perovskite Solar Modules", ACS Energy Lett., 2023, 8, 4885
(6) Dengxue Li, Zhi Xing, Xiangchuan Meng, Xiaotian Hu, Ting Hu, Yiwang Chen, " Selection of Functional Spacer Cations for Efficient 3D/2D Perovskite Solar Cells ", CCS Chem. 2023, 5, 781-801

### SUMMARY

It is an object of the present invention to at least improve scalability of a photoelectric device production, in particular for solar cells in combination with excellent performance and/or performance stability. It is an object of the present invention to allow efficiently fabrication of a solar cell with excellent performance and/or performance stability. It is an object of the present invention to allow efficiently fabrication of a photoelectric device performance based on a large-scale production. According to a particular aspect, the invention allows efficient fabrication of solar cells, due to cost efficiency and moderate environmental load.

In this respect, the present disclosure relates to a method for forming a perovskite layer of a perovskite solar cell, comprising steps of
coating a surface of a support heated to 30°C or more and 70°C or less with a first blade coating operation of applying a first liquid with a coating speed of less than 18 mm/s, the first liquid comprising a first solvent comprising a mix of polar aprotic solvents and a tin salt in a dissolved state in the first solvent,
evaporation of the first solvent for forming crystals with the tin salt,
annealing the crystals for obtaining an annealed layer on the substrate,
coating the annealed layer with a second blade coating operation of applying a second liquid, the second liquid comprising a second solvent comprising a lower alkyl alcohol and a halogenated lower alkyl alcohol, the second liquid further comprising salts of organic cations in the second solvent and being for obtaining a perovskite structure, layers of which are spaced apart from each other via the organic cations,
establishing the perovskite structure by heating for evaporation of the second solvent from the second liquid followed by annealing,

In the method a waiting time of 2s (2 seconds) or more and preferably 8s or less is observed between the end of the first blade coating operation and the step of evaporation of the first solvent. More preferable this waiting time is between 3s and 5s.

The perovskite structure is preferably a lead-free and tin-based perovskite structure and/or the perovskite structure is a quasi-2D perovskite structure or a 3D/2D perovskite structure, more preferably a 3D/2D perovskite structure.

The support may comprise a hole transport layer of the perovskite solar cell with the surface of the support being a surface of the hole transport layer and subjected to the first blade coating operation in the method. The hole transport layer may be provided on a patterned substrate, i.e. a substrate with an electrode pattern.

A waiting time is preferably also observed between the end of the second blade coating operation and the step following the step of coating with the second blade coating operation. Preferred values of this waiting time are between 3.5s and 4.5s.

According to preferences at least one of the following conditions is observed in at least one of the first and the second blade coating operations:
a temperature of the material to which liquid is applied for coating between 30°C and 60°C, more preferably between 40°C and 55°C,
a volume of the liquid between 5 and 30 µl per cm² of the surface of the material to which the liquid is applied,
a gap distance between 0.7 and 1.5 mm, preferably between 0.8 and 1.0 mm,
a blade coating speed between 5 mm/s and 15 mm/s, preferably between 8 mm/s and 12 mm/s.

The annealing before and/or the annealing after the second blade coating operation is typically immediately preceded by a transfer of an intermediate product into a chamber for the respective annealing, preferably within 7s or less, more preferably within 5s or less, most more preferably within 0.5s or more and 2.0s or less.

The annealing before and/or the annealing after the second blade coating operation is preferably performed at a temperature between 30°C and 60°C, more preferably between 40°C and 60°C, most preferably between 40°C and 55°C and preferably for at least 420s, more preferably at least 8 minutes.

An aspect of the invention is also a use of a liquid comprising a solvent comprising a mix of polar aprotic solvents and a tin salt, preferably a tin salt is a Sn(II) halide, preferably together with a reducing agent, preferably sodium hypophosphite, in the solvent as the first liquid in the method according to the invention, wherein the solvent comprises an alkyl amide and an organo-sulfoxide, wherein preferably the solvent is a binary mixture with a molar ratio between the alkyl amide and the organo-sulfoxide of 15:1 or more and 22:1 or less, more preferably 17.5:1 or more and 20.5:1 or less. The preferable addition of the reducing agent is one preventing an oxidation of Sn(II) of the tin salt. E.g. a molar ratio Sn(II):NaHP (NaHP= sodium hypophosphite) between 40:1 and 20:1 is suitable for this purpose. Preferably the invention's method is performed consistent with the invention's use of the liquid comprising a solvent comprising a mix of polar aprotic solvents and a tin salt.

An aspect of the invention is also a use of a liquid comprising a solvent comprising a lower alkyl alcohol and a halogenated lower alkyl alcohol and salts of organic cations in the solvent as the second liquid in the method according to the invention. Preferably the invention's method is also performed consistent with this use. The organic cations include preferably phenyl-ethyl ammonium (PEA) and formamidinium (FA) in a molar ratio between 1:4 and 1:7, preferably from providing the second liquid with a molar ratio PEAI:FAI (i.e. the iodides) between 1:5 and 1:7, more preferably between 1:55 and 1:65. A molar ratio between the lower alkyl alcohol and the halogenated lower alkyl alcohol is preferably 2:1 or more and 1:2 or less, more preferably 1.5:1 or more and 1:1.5 or less, most preferably more preferably 1.1:1 or more and 1:1.1 or less. According to preferences the lower alkyl alcohol is isopropyl alcohol and the halogenated lower alkyl alcohol is halogenated isopropyl alcohol and/or the second solvent comprises a lower alkyl alcohol and a halogenated lower alkyl alcohol having a lower boiling point and a higher polarity than the lower alkyl alcohol.

A photoelectric device according to the invention and preferably lead free comprises a hole transport layer, an electron transport layer, and a photoelectric conversion layer. Photoelectric devices of this type are known as discussed above but according to the invention the photoelectric conversion layer is one obtained by the method according to the invention (sandwiched between the hole transport layer and the electron transport layer with electrodes placed on each of the hole transport layer and the electron transport layer) and the photoelectric conversion layer has an area of 1.00 cm² or more and four regions not overlapping each other and each forming a square of 0.04 µm² in this area, of which regions an average of filling factor values measured for the sub-areas is 70% or more, each of the filling factor values deviating from the average filling factor values by 7 % or less, and an average of photoelectric conversion efficiency values measured for the sub-areas is 7.5% or more, each of the photoelectric conversion efficiency factor values deviating from the average of photoelectric conversion efficiency values by 7% or less. Four subsequently produced photoelectric devices, produced using the invention's method with identical conditions for the subsequently produced photoelectric devices may show a performance standard deviation of 0.2% or less or preferably 0.18% or less for PCE (photoelectric conversion efficiency) and less than 0.9% for FF (fill factor).

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
- FIG. 1 illustrates a schematic set of operations or processing stages involved in the method of the invention with blade coating, drying and annealing
- FIGS. 2A to 2C show AFM images of films obtained by coating a surface of a support with a blade coating operation of applying a liquid, drying an waiting,
- FIGS. 3A to 3E show values of PCE (photoelectric conversion efficiency) and FF (filling factor) of photoelectric devices formed with different conditions used before a second blade coating operation,
- FIG. 4 shows XRD spectra of perovskite layers obtained according to the method of the invention,
- FIGS. 5A to 5B show values of PCE (photoelectric conversion efficiency) and FF (filling factor) of photoelectric devices formed with different conditions used in a second blade coating operation,
- FIG. 6 shows and XRD spectrum of a perovskite layer obtained according to the method of the invention.

### DETAILED DESCRIPTION OF EMBODIMENTS

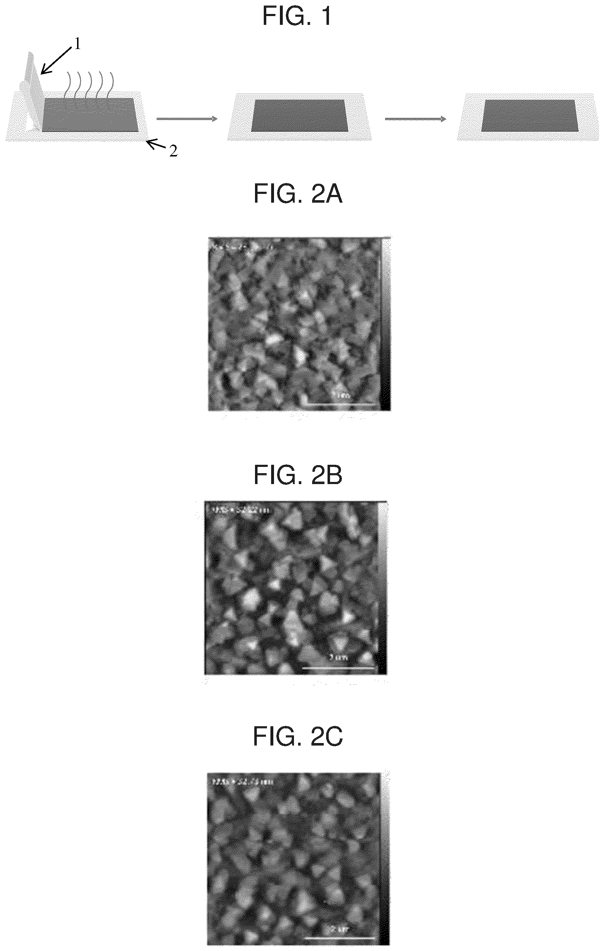

FIG. 1 illustrates a schematic set of operations or processing stages involved in the method of the invention with blade coating (left side of FIG. 1), drying (center portion of FIG. 1) and annealing (right side of FIG. 1). On the left side FIG. 1 illustrates a first blade coating operation of the invention's method as a first processing stage, in which a liquid or precursor solution is spread across a support 2 with surface tension produced by the blade 1 but conditions adjusted (as detailed below) against the formation of a meniscus on the support, which would give rise to coffee-ring-like structures during solvent evaporation, against the formation of a discontinuous film having large isolated crystal grains as grains from salt in the liquid, and to promote compactness and uniformity of the a deposited tin iodide film.

Processing stages as illustrated schematically in FIG. 1 may be repeated with the obtained product as a support and with a second liquid coated in the second blade coating operation of the invention's method.

A particular perovskite which may be formed using the invention's method is of the formula PEA₂FA₄Sn₅I₁₆ (PEA=Phenethylammonium, FA= Formamidinium) and of a quasi-2D perovskite structure. In this case a solvent component like e.g. DMSO is used to provide a strong coordination with Sn to facilitate a homogeneous nucleation and slow crystal growth but may disadvantageously promote in a coating liquid an oxidation from Sn²⁺ to Sn ⁴⁺ unless a reductant and/or a further solvent component is added for suppressing the oxidation. A high boiling point of the aforementioned solvent component like e.g. DMSO (dimethyl sulfoxide) with a potential to slow down a solvent evaporation rate after a blade coating operation, thus unfavorably promoting the formation of isolated grains is balanced by a lower boiling point of a further solvent component suitably admixed like e.g. in case of a solvent formed of DMF (N,N-dimethylformamide) and DMSO, preferably at a molar ratio of 15:1 or more and 22:1 or less, more preferably a DMF:DMSO ratio of 19:1.

Furthermore in the invention's method, for obtaining a homogeneous coating film or crystal surface morphology, a coating liquid with a tin salt is blade coated with a suitable temperature, like e.g. 50°C support temperature, and speed of the blade, like e.g. 10 mm/s, preferably in order to favorably control a solute-saturation rate and diffusion rate of remaining solvent. Accordingly coating parameters are set for achieving a uniform and pinhole-free tin perovskite thin film.

Following to the blade coating stage illustrated on the left side of FIG. 1 and after the blade is removed a waiting time is observed according to the invention's method to obtain a favorable morphology and mesoporous structure and/or avoid evaporation of the residual solvent present at the backside of the support. An exemplary efficient waiting time is 4 s and a preferred range is between 2s and 6s.

As mentioned above processing stages as illustrated schematically in FIG. 1 may be repeated with a second liquid coated in a second blade coating operation of the invention's method. This allows a conversion of a layer with the hexagonal tin iodide structural units into a perovskite structure with larger unit cell parameters. Here a suitable exemplary solvent component for a coating liquid is isopropyl alcohol (IPA) which in order to obtain favorable orientation of the perovskite is used with a suitable co-solvent, like e.g. hexafluoro-2-propanol (HFP). Generally in the second blade coating operation of the invention's method a lower alkyl alcohol may be combined with a co-solvent showing a stronger capacity to make hydrogen bonding and a lower boiling point. Amounts and/or amount ratios of the organic cations in the second blade coating operation like e.g. the cations of the salts FAI and PEAI are used, e.g. a molar ratio PEAI: FAI of 1:6. Depending on the amounts and/or amount ratios it is also possible with the invention's method to from a perovskite of the formula PEAₓFA₄Sn₃I₁₆ (PEA=Phenethylammonium, FA= Formamidinium) and of a 3D/2D perovskite structure.

Exemplary and particularly favorable parameters for the second blade coating operation in the invention's method are a molar solvent ratio IPA:HFP of 1:1, a coating temperature of 50 □ (of the material subjected to coating), a coating speed of 10 mm/s (of the blade used for blade coating), and waiting time of 2 s following to the blade coating stage and after the blade is removed.

Above discussed adjustments may be set to obtain for four subsequently produced devices with the invention's method a performance standard deviation of 0.2% or less or preferably 0.18% or less for PCE (photoelectric conversion efficiency) and less than 0.9%, preferably less than 0.88% for FF (filling factor).

Under a particular aspect a tin based (lead-free) solar cell produced according to the invention has a PCE of 10% or more, more preferably 10.5% or more, and preferably as a device with an area of 1 cm² or more, preferably 1.5 cm² or more, and it may preferably have a FF of 78% or more. A Sn perovskite device prepared using the method according to the invention may be one, which maintains over 88%, preferably over 90% of its initial efficiency after up to 4 months in an inert atmosphere (dry nitrogen).

### EXAMPLE OPERATIONS AND RESULTS

### Materials

Materials were obtained from suppliers and with purity grades as indicated hereafter.

PEDOT: PSS (trade name AI 4083) was purchased form Heraeus. Formamidinium iodide (FAI, >98%). Phenethylammonium iodide (PEAI, >98%), methylamine chloride (MAC1, >98%), and bathocuproine (BCP, >99%) were obtained from TCI EUROPE N.V.. N, N-dimethylformamide (DMF, 99.8%) and dimethyl sulfoxide (DMSO, 99.8%) were acquired from Alfa Aesar. Tin (II) iodide (SnI₂, 99.99%), Tin (II) Fluoride (SnF₂, 99%), buckminsterfullerene (C60, 99.9%), ethylenediammonium diiodide (EDAI₂, >98%), sodium hypophosphite (NaHP, >99%), hexafluoro-2-propanol (HFP, >99%), and isopropyl alcohol (IPA, 99.9%) were obtained from Sigma-Aldrich. Silver rods (Ag, 99.99%) were bought from Umicore.

### Materials to be subjected to the first coating operation

A patterned ITO substrate with dimensions of 30 mm (length) × 30 mm (width) × 0.7 mm (height) was cleaned, dried, and UV-Ozon treated sequentially in a preparation for a thin film deposition, i.e. coating with PEDOT:PSS. The PEDOT:PSS films were fabricated by spin coating the substrate at 3000 rpm for 60 s and annealed at 140°C for 20 min in air and the obtained products were transferred to a glove box for depositions by blade coating as described hereafter.

### Samples to be subjected to the second coating operation

A first liquid being an inorganic precursor (or perovskite solution) was prepared by mixing materials according to the specifications in table 1 and stirring overnight at room temperature and then filtering using a 0.20 µm PTFE filter before use.

**Table 1**

| 1^{st} step solution (inorganic precursor) component for the 1^{st} blade coating operation | amount |
|---|---|
| SnI₂ | 0.6 mmol |
| SnF₂ | 0.06 mmol |
| EDAI₂ | 0.02 mmol |
| NaHP | 0.02 mmol |
| DMF:DMSO | 1 ml, molar ratio of 19:1 |

Further variants of the first liquid were prepared in the same manner but so as to obtain a set of first coating liquid variants with molar DMF:DMSO ratios of 1:0, 19:1, 9:1, and 4:1, respectively.

20 µl of the first coating liquid variant with a molar DMF:DMSO ratio of 19:1 was used for a set of operations as illustrated in FIG. 1 with test values for specific processing parameters and final results illustrated in related Figures as indicated in table 2.

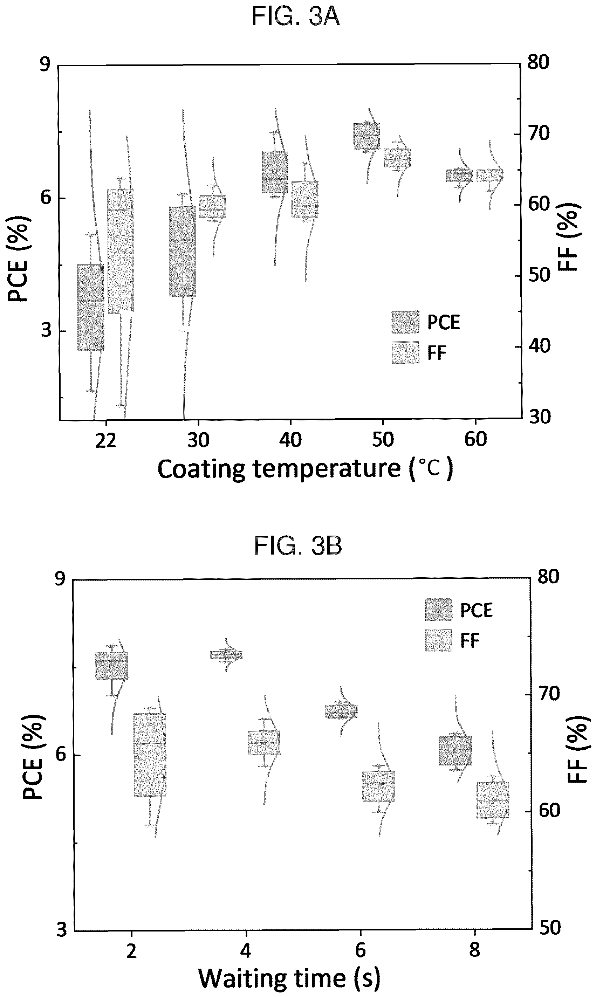

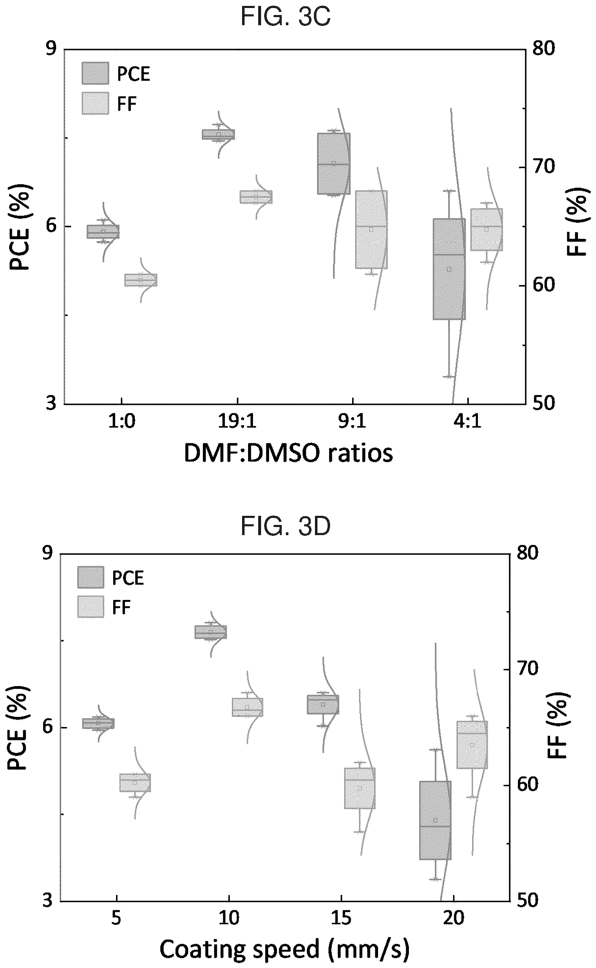

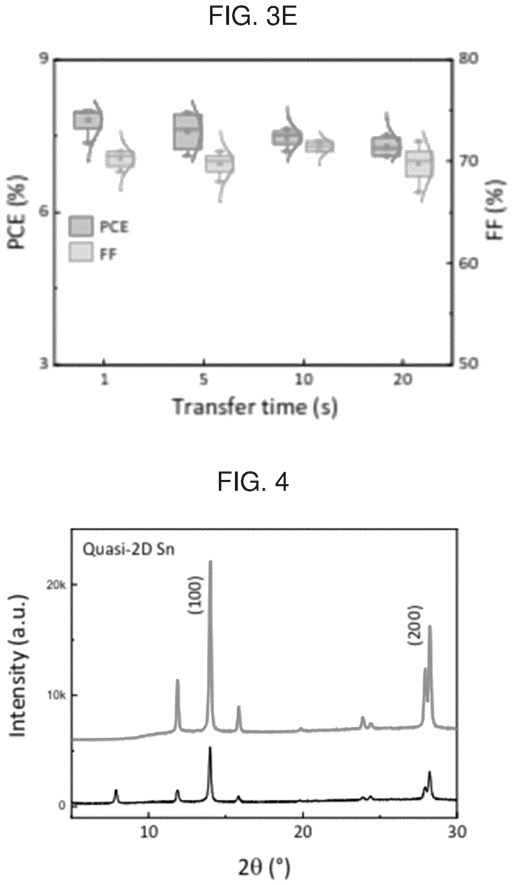

Moreover (as likewise indicated in table 2) 20 µl of each first coating liquid variant was used for the set of operations with the test values of 0.9 mm gap distance, 50°C coating/deposition temperature, 4s waiting time after coating (until drying), 10 mm/s blade coating speed, 1s transfer time after waiting and until annealing, and an annealing temperature of 50°C and an annealing time of 10 min and with final results illustrated in FIG. 3C. The sample obtained from this set of operations with these test values and the first coating liquid variant with a molar DMF:DMSO ratio of 19:1 was further processed as described below, particularly by subjecting it to a second blade coating operation using IPA (isopropyl alcohol) and HFP (hexafluoro-2-propanol) as solvent components.

**Table 2**

| **parameter** | **tested values** | **related FIG.** |
|---|---|---|
| gap distance | 0.9 mm | FIGS. 3A-3E |
| coating/deposition temperature | 22°C, 30°C, 40°C, 50°C, 60°C | FIG. 3A |
| coating/deposition temperature | 50°C | FIGS. 3B-3E |
| waiting time after coating (until drying) | 0s, 2s, 4s, 6s, 8s | FIG. 3B |
| waiting time after coating (until drying) | 4s | FIGS. 3A, 3C-3E |
| blade coating speed | 5 mm/s, 10 mm/s, 15 mm/s, 20 mm/s | FIG. 3D |
| blade coating speed | 10 mm/s | FIGS. 3A-3C, 3E |
| transfer time after waiting and until annealing | 1s, 5s, 10s, 20s | FIG. 3E |
| transfer time after waiting and until annealing | 1s | FIGS. 3A-3D |
| annealing temperature and time | 50°C, 10 min | FIGS. 3A-3E |

AFM images were recorded from the samples obtained from the first coating liquid variant with a molar DMF:DMSO ratio of 19:1 and the waiting times after coating (until drying) of 4s, 6s, and 8s, respectively.

FIG. 2A shows the AFM image from sample obtained with the waiting time of 4s and a horizontal scale bar corresponding to 1 µm.

FIG. 2B shows the AFM image from sample obtained with the waiting time of 4s and a horizontal scale bar corresponding to 2 µm.

FIG. 2C shows the AFM image from sample obtained with the waiting time of 4s and a horizontal scale bar corresponding to 2 µm.

### Samples to be processed into photoelectric devices

Alternatives of a second liquid, namely for a quasi-2D Sn system and for a 3D/2D Sn system, and being an organic precursor (solution) were prepared by mixing materials according to the specifications in table 3 and stirring overnight at room temperature and then filtering using a 0.20 µm PTFE filter before use.

**Table 3**

| 2^{nd} step solution for the 2^{nd} blade coating operation | quasi-2D Sn system (precursor) | 3D/2D Sn system (precursor) |
|---|---|---|
| FAI | 0.3 mmol or varied | 0.3 mmol |
| PEAI | **0.15 mmol** or varied, | **0.05 mmol,** |
| | molar ratio PEAI:FAI of 1:2 | molar ratio PEAI:FAI of 1:6 |
| MACl | 0.05 mmol | 0.05 mmol |
| **IPA:HFP** | 1ml, | 1ml |
| | molar ratio IPA:HFP of 1:1 | molar ratio IPA:HFP of 1:1 |

As mentioned above the sample obtained from the first coating liquid variant with a molar DMF:DMSO ratio of 19:1 was further processed by subjecting it to a second blade coating operation using IPA (isopropyl alcohol) and HFP (hexafluoro-2-propanol) as solvent components. Accordingly, 20 µl of the second liquid for the quasi-2D Sn system was used for a set of operations as illustrated in FIG. 1 but using the sample obtained from the first coating liquid variant with a molar DMF:DMSO ratio of 19:1 as a support (material subjected to the blade coating with this second liquid) and again using
a) 0.9 mm gap distance,
b) a coating/deposition temperature of 50°C,
c) a blade coating speed of 10 mm/s,
d) a waiting time after coating (until drying) of 4s,
e) a transfer time after waiting and until annealing of 1s,
f) an annealing temperature 50°C,
g) an annealing time of 10 min.

As mentioned above the sample obtained from the first coating liquid variant with a molar DMF:DMSO ratio of 19:1 was further processed by subjecting it to a second blade coating operation using IPA (isopropyl alcohol) and HFP (hexafluoro-2-propanol) as solvent components. Accordingly, also 20 µl of the second liquid for the 3D/2D Sn system was used for a set of operations as illustrated in FIG. 1 but using the sample obtained from the first coating liquid variant with a molar DMF:DMSO ratio of 19:1 as a support (material subjected to the blade coating with this second liquid) and again using it with
a) 0.9 mm gap distance,
b) a coating/deposition temperature of 50°C,
c) a blade coating speed of 10 mm/s,
d) a waiting time after coating (until drying) of 4s,
e) a transfer time after waiting and until annealing of 1s,
f) an annealing temperature 50°C,
g) an annealing time of 10 min.

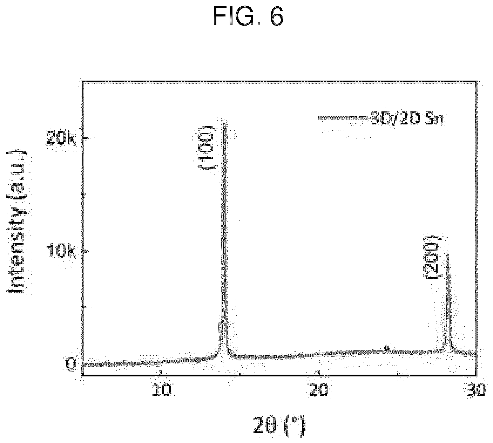

The XRD pattern recorded from the obtained sample is shown in FIG. 6 and an excellently homogeneous surface was observed on this sample.

As described below the samples obtained with the alternatives of the second liquid, for a quasi-2D Sn system and for a 3D/2D Sn system, were processed into photoelectric devices with 1 cm² device area which were characterized with characterization specifications described below and were particularly characterized with regard the 4 separate (non-overlapping) surface regions on each device each having an area of 0.04 cm² so as to obtain results shown in table 4 for the device from the second liquid for the quasi-2D Sn system and table 5 for the device from the second liquid for the 3D/2D Sn system.

**Table 4 - results from the quasi-2D Sn system**

| Device region | V_{OC} (V) | J_{SC} (mA/cm²) | FF (%) | PCE (%) |
|---|---|---|---|---|
| Area 1 (0.04 cm²) | 0.577 | 19.87 | 71 | 8.16 |
| Area 2 (0.04 cm²) | 0.542 | 20.25 | 68 | 7.45 |
| Area 3 (0.04 cm²) | 0.567 | 19.53 | 72 | 7.98 |
| Area 4 (0.04 cm²) | 0.572 | 19.61 | 72 | 8.06 |

**Table 5 - results from the quasi-3D/2D Sn system**

| Device area | V_{OC} (V) | J_{SC} (mA/cm²) | FF (%) | PCE (%) |
|---|---|---|---|---|
| 0.04 cm² | 0.672 | 20.75 | 77 | 10.70 |
| 1.00 cm² | 0.664 | 20.01 | 70 | 9.36 |

The preparation of the sample obtained with the alternative of the second liquid for a 3D/2D Sn system and it's processing into a photoelectric device with 1 cm² device area with a characterization specifications described below was varied in each of a value of a processing parameter in or after blade coating the second liquid to obtain related results as indicated in table 6. Thus, for each result in table 6 a device was produced with the above listed values a) to g) except that one of these values was varied as indicated in table 6.

**Table 6**

| **parameter** | **tested values** | **result** |
|---|---|---|
| coating/deposition temperature | 22°C, 30°C, 40°C, 50°C, 60°C | PCE=9.21% using 22°C |
| | | PCE=9.26% using 30°C |
| | | PCE=10.11% using 40°C |
| | | PCE=10.34% using 50°C |
| | | PCE=9.91% using 60°C |
| waiting time after coating (until drying) | 2s, 4s, 6s, 8s | PCE=10.30 using 2s |
| | | PCE=10.11% using 4s |
| | | PCE=8.77% using 6s |
| | | PCE=8.76% using 8s |
| blade coating speed | 8 mm/s, 10 mm/s, 12 mm/s, 15 mm/s | PCE=9.86 using 8 mm/s |
| | | PCE=10.12% using 10 mm/s |
| | | PCE=9.96% using 12 mm/s |
| | | PCE=9.90% using 15 mm/s |
| transfer time after waiting and until annealing | 1s, 5s, 10s, 20s | PCE=10.12 using 1s |
| | | PCE=10.19% using 5s |
| | | PCE=9.89% using 10s |
| | | PCE=9.37% using 20s |

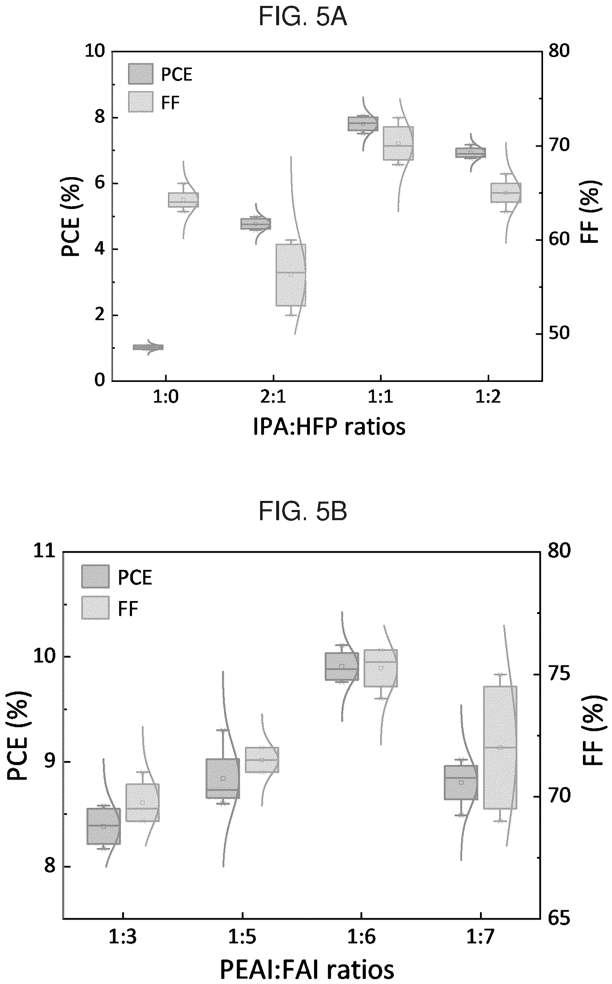

As mentioned above the sample obtained from the first coating liquid variant with a molar DMF:DMSO ratio of 19:1 was further processed by subjecting it to a second blade coating operation using IPA (isopropyl alcohol) and HFP (hexafluoro-2-propanol) as solvent components. Accordingly 20 µl of the second liquid for the quasi-2D Sn system was used for the set of operations using the sample obtained from the first coating liquid variant with a molar DMF:DMSO ratio of 19:1 as a material subjected to the blade coating with this second liquid using above listed processing values a) to g) to obtain a sample to be processed into a photoelectric device. This preparation of a sample to be processed into a photoelectric device was repeated but with varying the second liquid so as to obtain samples (which are then processed into devices as described below) using molar ratios of IPA:HFP of the solvent of 1:0, 2:1, 1:1, and 1:2. Obtained XRD patterns of FIG. 4 show the upper pattern from the sample obtained with the molar ratio of IPA:HFP of 1:1 and the lower pattern from the sample obtained with the molar ratio of IPA:HFP of 1:0. Further final results of device characterizations are shown in FIG. 5A.

The same preparation of a sample to be processed into a photoelectric device was repeated maintaining in the second liquid the molar ratio of IPA:HFP of the solvent of 1:1 but varying the molar ratio of PEAI:FAI so as to obtain samples (which are then processed into devices as described below) using molar ratios of PEAI:FAI in the solvent of 1:3, 1:5, 1:6, and 1:7, and further final results shown in FIG. 5B.

### Photoelectric devices

Each of the obtained samples to be processed into photoelectric devices was converted into a device by transferring it into a vacuum chamber (< 10⁻⁷ mbar), thermally evaporating (vapor depositing) subsequently
- 30 nm of C60,
- 6 nm of BCP, and
- 100 nm of Ag.

Accordingly, the samples obtained from the first coating liquid variants and variants of processing variations before the second blade coating operation described above were processed into devices characterized with PCE and FF measurements to obtain the results shown in FIGS. 3A-3E.

Accordingly, the samples obtained from the second coating liquid variants and processing variations of or after the second blade coating operation described above were processed into devices characterized with PCE and FF measurements to obtain the results shown in FIGS. 5A-5B and tables 4 to 6.

In FIGS. 3A-3E, 5A and 5B dark shaded areas indicate PCE measurements, light shaded areas indicate FF measurements and indicated PCE and FF measurements of each device are laterally spaced apart from each other for better visibility. Furthermore error bars are indicated.

A J-V behavior can be defined by the following equation 1: $- \frac{dV}{dJ} = \frac{{nK}_{B} T}{q {\left({J}_{SC}-J\right)}^{- 1}} + {R}_{s}$ (1)
where n, K_{B}, R_{S}, q, and T are the ideality factor, Boltzmann constant, series resistance, elementary charge, and absolute temperature, respectively. The (3D/2D Sn device) described above and obtained from the sample showing the XRD pattern of FIG. 6 exhibited a lower R_{S} value of 1.35 Ωcm² compared with the (quasi-2D) device described above and obtained from the sample showing the upper XRD pattern of FIG. 4 with and R_{S} value of 1.62 Ωcm², which is related to the improved FF value. A lower leakage dark current suggested efficient charge transport and decreased recombination loss in the 3D/2D Sn device, with a shunt resistance (Rₛₕ) of 72.15 kΩcm² and an Rₛ of 2.91 Ωcm². Electrochemical impedance spectroscopy (EIS) also confirmed for the 3D/2D device a lower charge transfer resistance (R_{CT}) and larger recombination resistance (R_{rec}). Nyquist plots of an EIS measurement demonstrated an R_{CT} of 328.02 Ω and an R_{rec} of 1941.30 Ω for the 3D/2D device, compared to an R_{CT} of 694.59 Ω and an R_{rec} of 551.81 Ω for the quasi-2D device, which is attributed to the low trap density in the corresponding perovskite films.

A maximum FF (FF max ) can be calculated with the equation 2 and 3: ${FF}_{max} = \frac{{V}_{oc , n} - ln \left({V}_{oc , n}+0.72\right)}{{V}_{oc , n} + 1}$ (2) ${V}_{oc , n} = \frac{{qV}_{oc}}{{nK}_{B} T}$ (2)

Accordingly, calculated FF max are 82.5% and 84.3% for quasi-2D and 3D/2D devices (the quasi-2D device described above and obtained from the sample showing the upper XRD pattern of FIG. 4 and the 3D/2D Sn device described above and obtained from the sample showing the XRD pattern of FIG. 6), respectively. Trap-assisted non-radiative loss and charge transport loss are lower in the 3D/2D Sn device, indicating inhibited non-radiative recombination and improved charge transport. Therefore, multiple characterizations consistently indicate that low recombination losses and high charge transport are determining the improvement of the FF, further illustrating the importance of the present disclosure's deposition concept.

### Characterization

Characterizations addressed above were performed in accordance with common practice unless otherwise indicated and the following specifications and equipment were used for characterizations.

The J-V curves of the devices were measured at 295 K using a Keithley 2400 source meter under simulated AM 1.5 G solar illumination in a nitrogen-filled glove box. The light intensity was calibrated to 100 mW cm⁻² using a Si reference cell. A shadow mask with an area of 0.04 cm² was used to exclude lateral contributions beyond the device area. EQE measurements were conducted with a home-built set-up, where the integrated current density was multiplied by a mismatch factor value of 1.10. This correction accounts for the slightly different spectral responses of the perovskite and silicon solar cells used to calibrate the set-up. The AFM morphology of perovskite films was investigated using a Bruker Multimode eight microscope in ScanAsyst mode, and SEM images were tracked with NovaNano SEM 650 microscope at an acceleration voltage of 15 kV. Optical microscopy images were recorded with an OLYMPUS BX51RF microscope in a glovebox. XRD patterns were recorded using a Bruker D8 Advance X-ray diffractometer with a Cu Kα source (λ = 1.54 Å) and a Lynxeye detector in air. A UV-Vis-NIR spectrophotometer (UV 3600) was used to record the UV-vis spectra of the perovskite films. GIWAXS measurements were conducted using a MINA X-ray scattering instrument with a Cu rotating anode source (λ = 1.5413 Å). The EIS spectra were analyzed by a SP-200 biologic potentiostat with an electrochemical impedance spectroscopy analyzer in a range from 1 Hz to 1MHz. Steady-state and time-resolved photoluminescence (PL) measurements were conducted by exciting the samples with the second harmonic (400 nm) of a mode-locked Ti-Sapphire laser (Mira 900, Coherent). Steady state PL spectra are recorder with an Andor InGaAs inline detector, while Time resolved measurements were recorded with a Streak-Camera from Hamamatsu Japan both connected to the same monochromator.

### Performance and applications

The present disclosure enables reproducibility and device uniformity like with more than 90% of a photoelectric device's PCE retained after storage in an inert atmosphere for over 4 months and degraded by less than 3% after 12 hours, reduced non-radiative recombination and excellent charge transport for PCE and FF using industry-compatible technique. The invention's method may be used to produce photoelectric devices, in particular solar cells in an efficient manner. The invention's uses may render the production of photoelectric devices, in particular solar cells efficient. The invention's photoelectric device, in particular a solar cell of the invention shows relatively large homogeneous device surface area and homogeneous performance over this area.

Although the present disclosure refers to specific exemplary embodiments, modifications may be provided to these examples without departing from the general scope of the invention as defined by the claims. In particular, individual characteristics of the different illustrated/mentioned embodiments may be combined in additional embodiments. Therefore, the description and the drawings should be considered in an illustrative rather than in a restrictive sense.

## Claims

1. A method for forming a perovskite layer of a perovskite solar cell, comprising steps of coating a surface of a support heated to 30°C or more and 70°C or less with a first blade coating operation of applying a first liquid with a coating speed of less than 18 mm/s, the first liquid comprising a first solvent comprising a mix of polar aprotic solvents and a tin salt in a dissolved state in the first solvent,
evaporation of the first solvent for forming crystals with the tin salt,
annealing the crystals for obtaining an annealed layer on the support,
coating the annealed layer with a second blade coating operation of applying a second liquid, the second liquid comprising a second solvent comprising a lower alkyl alcohol and a halogenated lower alkyl alcohol, the second liquid further comprising salts of organic cations in the second solvent and being for obtaining a perovskite structure, layers of which are spaced apart from each other via the organic cations,
establishing the perovskite structure by heating for evaporation of the second solvent from the second liquid followed by annealing,
wherein a waiting time of 2s or more is observed between the end of the first blade coating operation and the step following the step of coating with the first blade coating operation.

2. The method according to claim 1, wherein the perovskite structure is a lead-free and tin-based perovskite structure.

3. The method according to claim 1 or 2, wherein the perovskite structure is a quasi-2D perovskite structure or a 3D/2D perovskite structure.

4. The method according to claim 3, wherein the photoelectric conversion layer is a 3D/2D perovskite structure.

5. The method according to any of the preceding claims, wherein the support comprises a hole transport layer of the perovskite solar cell and the surface of the support is a surface of the hole transport layer and subjected to the first blade coating operation in the method.

6. The method according to any of the preceding claims, wherein a waiting time of between 3.5s and 4.5s is observed between the end of the second blade coating operation and the step following the step of coating with the second blade coating operation.

7. The method according to any of the preceding claims, wherein at least one of the following conditions is observed in at least one of the first and the second blade coating operations:
a temperature of the material to which liquid is applied for coating between 50°C and 60°C,
a volume of the liquid between 5 and 30 µl per cm² of the surface of the material to which the liquid is applied,
a gap distance between 0.7 and 1.5 mm,
a blade coating speed between 5 mm/s and 15 mm/s.

8. The method according to any of the preceding claims, wherein prior to the annealing before and/or the annealing after the second blade coating operation is immediately preceded by a transfer of an intermediate product into a chamber for the respective annealing within 7s or less.

9. The method according to any of the preceding claims, wherein the annealing before and/or the annealing after the second blade coating operation is performed at a temperature between 40°C and 60°C and for at least 420s.

10. A use of a liquid comprising a solvent comprising a mix of polar aprotic solvents and a tin salt in the solvent as the first liquid in the method according to any of the preceding claims, wherein the solvent comprises an alkyl amide and an organo-sulfoxide.

11. The use according to claim 10, wherein the solvent is a binary mixture with a molar ratio between the alkyl amide and the organo-sulfoxide of 15:1 or more and 22:1 or less.

12. The use according to claim 10 or 11, wherein the liquid contains a reducing agent and the tin salt is a Sn(II) halide.

13. A use of a liquid comprising a solvent comprising a lower alkyl alcohol and a halogenated lower alkyl alcohol and salts of organic cations in the solvent as the second liquid in the method according to any of claims 1 to 9,
wherein the organic cations include phenyl-ethyl ammonium (PEA) and formamidinium (FA) in a molar ratio between 1:4 and 1:7.

14. The use according to claim 13, wherein a molar ratio between the lower alkyl alcohol and the halogenated lower alkyl alcohol is 1.5:1 or more and 1:1.5 or less.

15. A photoelectric device comprising
a hole transport layer,
an electron transport layer,
a photoelectric conversion layer obtained by the method according to any of claims 1 to 9 and sandwiched between the hole transport layer and the electron transport layer, and
electrodes on each of the hole transport layer and the electron transport layer,
wherein
the photoelectric conversion layer has an area of 1.00 cm² or more and four regions not overlapping each other and each forming a square of 0.04 µm² in this area, of which regions
an average of filling factor values measured for the sub-areas is 70% or more, each of the filling factor values deviating from the average filling factor values by 7 % or less, and
an average of photoelectric conversion efficiency values measured for the sub-areas is 7.5% or more, each of the photoelectric conversion efficiency factor values deviating from the average of photoelectric conversion efficiency values by 7% or less.

## Amended claims

### Amended claims in accordance with Rule 137(2) EPC.

**1.** A method for forming a perovskite layer of a perovskite solar cell, comprising steps of
coating a surface of a support heated to 30°C or more and 70°C or less with a first blade coating operation of applying a first liquid with a blade (1) at a coating speed of less than 18 mm/s, the first liquid comprising a first solvent comprising a mix of polar aprotic solvents and a tin salt in a dissolved state in the first solvent,
evaporation of the first solvent for forming crystals with the tin salt,
annealing the crystals for obtaining an annealed layer on the support,
coating the annealed layer with a second blade coating operation of applying a second liquid, the second liquid comprising a second solvent comprising a lower alkyl alcohol and a halogenated lower alkyl alcohol, the second liquid further comprising salts of organic cations in the second solvent and being for obtaining a perovskite structure, layers of which are spaced apart from each other via the organic cations,
establishing the perovskite structure by heating for evaporation of the second solvent from the second liquid followed by annealing,
wherein a waiting time of 2s or more is observed between the end of the first blade coating operation and the step of evaporation of the first solvent.

**2.** The method according to claim 1, wherein the perovskite structure is a lead-free and tin-based perovskite structure.

**3.** The method according to claim 1 or 2, wherein the perovskite structure is a quasi-2D perovskite structure or a 3D/2D perovskite structure.

**4.** The method according to claim 3, wherein the photoelectric conversion layer is a 3D/2D perovskite structure.

**5.** The method according to any of the preceding claims, wherein the support comprises a hole transport layer of the perovskite solar cell and the surface of the support is a surface of the hole transport layer and subjected to the first blade coating operation in the method.

**6.** The method according to any of the preceding claims, wherein a waiting time of between 3.5s and 4.5s is observed between the end of the second blade coating operation and the step following the second blade coating operation.

**7.** The method according to any of the preceding claims, wherein at least one of the following conditions is observed in at least one of the first and the second blade coating operations:
a temperature of the material to which liquid is applied for coating between 50°C and 60°C,
a volume of the liquid between 5 and 30 µl per cm² of the surface of the material to which the liquid is applied,
a gap distance between 0.7 and 1.5 mm,
a blade coating speed between 5 mm/s and 15 mm/s.

**8.** The method according to any of the preceding claims, wherein prior to the annealing before and/or the annealing after the second blade coating operation is immediately preceded by a transfer of an intermediate product into a chamber for the respective annealing within 7s or less.

**9.** The method according to any of the preceding claims, wherein the annealing before and/or the annealing after the second blade coating operation is performed at a temperature between 40°C and 60°C and for at least 420s.

**10.** A use of a liquid comprising a solvent comprising a mix of polar aprotic solvents and a tin salt in the solvent as the first liquid in the method according to any of the preceding claims, wherein the solvent comprises an alkyl amide and an organo-sulfoxide.

**11.** The use according to claim 10, wherein the solvent is a binary mixture with a molar ratio between the alkyl amide and the organo-sulfoxide of 15:1 or more and 22:1 or less.

**12.** The use according to claim 10 or 11, wherein the liquid contains a reducing agent and the tin salt is a Sn(II) halide.

**13.** A use of a liquid comprising a solvent comprising a lower alkyl alcohol and a halogenated lower alkyl alcohol and salts of organic cations in the solvent as the second liquid in the method according to any of claims 1 to 9,
wherein the organic cations include phenyl-ethyl ammonium (PEA) and formamidinium (FA) in a molar ratio between 1:4 and 1:7.

**14.** The use according to claim 13, wherein a molar ratio between the lower alkyl alcohol and the halogenated lower alkyl alcohol is 1.5:1 or more and 1:1.5 or less.

**15.** A photoelectric device comprising
a hole transport layer,
an electron transport layer,
a photoelectric conversion layer obtained by the method according to any of claims 1 to 9 and sandwiched between the hole transport layer and the electron transport layer, and
electrodes on each of the hole transport layer and the electron transport layer,
wherein
the photoelectric conversion layer has an area of 1.00 cm² or more and four regions not overlapping each other and each forming a square of 0.04 µm² in this area, of which regions
an average of filling factor values measured for the sub-areas is 70% or more, each of the filling factor values deviating from the average filling factor values by 7 % or less, and
an average of photoelectric conversion efficiency values measured for the sub-areas is 7.5% or more, each of the photoelectric conversion efficiency factor values deviating from the average of photoelectric conversion efficiency values by 7% or less.

**1.** A method for forming a perovskite layer of a perovskite solar cell, comprising steps of
coating a surface of a support heated to 30°C or more and 70°C or less with a first blade coating operation of applying a first liquid with a blade (1) at a coating speed of less than 18 mm/s, the first liquid comprising a first solvent comprising a mix of polar aprotic solvents and a tin salt in a dissolved state in the first solvent,
evaporation of the first solvent for forming crystals with the tin salt,
annealing the crystals for obtaining an annealed layer on the support,
coating the annealed layer with a second blade coating operation of applying a second liquid, the second liquid comprising a second solvent comprising a lower alkyl alcohol and a halogenated lower alkyl alcohol, the second liquid further comprising salts of organic cations in the second solvent and being for obtaining a perovskite structure, layers of which are spaced apart from each other via the organic cations,
establishing the perovskite structure by heating for evaporation of the second solvent from the second liquid followed by annealing,
wherein a waiting time of 2s or more is observed between the end of the first blade coating operation and the step of evaporation of the first solvent.

**2.** The method according to claim 1, wherein the perovskite structure is a lead-free and tin-based perovskite structure.

**3.** The method according to claim 1 or 2, wherein the perovskite structure is a quasi-2D perovskite structure or a 3D/2D perovskite structure.

**4.** The method according to claim 3, wherein the photoelectric conversion layer is a 3D/2D perovskite structure.

**5.** The method according to any of the preceding claims, wherein the support comprises a hole transport layer of the perovskite solar cell and the surface of the support is a surface of the hole transport layer and subjected to the first blade coating operation in the method.

**6.** The method according to any of the preceding claims, wherein a waiting time of between 3.5s and 4.5s is observed between the end of the second blade coating operation and the step following the second blade coating operation.

**7.** The method according to any of the preceding claims, wherein in the first solvent, a molar ratio between the lower alkyl alcohol and the halogenated lower alkyl alcohol is 1.5:1 or more and 1:1.5 or less and at least one of the following conditions is observed in at least one of the first and the second blade coating operations:
a temperature of the material to which liquid is applied for coating between 50°C and 60°C,
a volume of the liquid between 5 and 30 µl per cm² of the surface of the material to which the liquid is applied,
a gap distance between 0.7 and 1.5 mm,
a blade coating speed between 5 mm/s and 15 mm/s.

**8.** The method according to claim 7, wherein prior to the annealing before and/or the annealing after the second blade coating operation is immediately preceded by a transfer of an intermediate product into a chamber for the respective annealing within 7s or less.

**9.** The method according to claim 8, wherein the annealing before and/or the annealing after the second blade coating operation is performed at a temperature between 40°C and 60°C and for at least 420s.

**10.** A use of a liquid comprising a solvent comprising a mix of polar aprotic solvents and a tin salt in the solvent as the first liquid in the method according to any of the preceding claims, wherein the solvent comprises an alkyl amide and an organo-sulfoxide.

**11.** The use according to claim 10, wherein the solvent is a binary mixture with a molar ratio between the alkyl amide and the organo-sulfoxide of 15:1 or more and 22:1 or less.

**12.** The use according to claim 10 or 11, wherein the liquid contains a reducing agent and the tin salt is a Sn(II) halide.

**13.** A use of a liquid comprising a solvent comprising a lower alkyl alcohol and a halogenated lower alkyl alcohol and salts of organic cations in the solvent as the second liquid in the method according to any of claims 1 to 9,
wherein the organic cations include phenyl-ethyl ammonium (PEA) and formamidinium (FA) in a molar ratio between 1:4 and 1:7.

**14.** The use according to claim 13, wherein a molar ratio between the lower alkyl alcohol and the halogenated lower alkyl alcohol is 1.5:1 or more and 1:1.5 or less.

**15.** A photoelectric device comprising
a hole transport layer,
an electron transport layer,
a photoelectric conversion layer obtained by the method according to claims 2 and 9 and sandwiched between the hole transport layer and the electron transport layer, and
electrodes on each of the hole transport layer and the electron transport layer,
wherein
the photoelectric conversion layer has an area of 1.00 cm² or more and four regions not overlapping each other and each forming a square of 0.04 µm² in this area, of which regions
an average of filling factor values measured for the sub-areas is 70% or more, each of the filling factor values deviating from the average filling factor values by 7 % or less, and
an average of photoelectric conversion efficiency values measured for the sub-areas is 7.5% or more, each of the photoelectric conversion efficiency factor values deviating from the average of photoelectric conversion efficiency values by 7% or less.
